(19) **Europäisches Patentamt**
**European Patent Office**
**Office européen des brevets**

(11) **EP 4 733 789 A1**

(12) **EUROPEAN PATENT APPLICATION**

(43) Date of publication:
29.04.2026 Bulletin 2026/18

(21) Application number: 24209026.4

(22) Date of filing: 25.10.2024

(51) International Patent Classification (IPC):
*G01R 31/396* (2019.01)

(52) Cooperative Patent Classification (CPC):
G01R 31/396; G01R 31/367; G01R 31/392;
G01R 31/007

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: **Volvo Car Corporation**
405 31 Göteborg (SE)

(72) Inventors:
• **HANSSON, Fredrik**
40531 Göteborg (SE)
• **Genson, Jerrad**
40531 Göteborg (SE)

(74) Representative: **Kransell & Wennborg KB**
P.O. Box 2096
403 12 Göteborg (SE)

(54) **METHOD FOR DETECTING AN ANOMALY IN ONE OR MORE CELLS OF A PLURALITY OF BATTERY CELLS FOR A VEHICLE, METHOD FOR CONTROLLING A BATTERY ASSEMBLY FOR A VEHICLE, DATA PROCESSING APPARATUS, COMPUTER PROGRAM, COMPUTER-READABLE STORAGE MEDIUM AND USE**

(57) The disclosure relates to a method for detecting an anomaly in one or more battery cells (16) of a plurality of battery cells (16) for a vehicle (10). The method comprises obtaining first data (D1) indicative of a deviation (dSoC) of a state of charge per battery cell (16) of at least a subset (18) of the plurality of battery cells from a first statistical parameter. The method also comprises obtaining second data (D2) indicative of a deviation (dSoH) of a state of health per battery cell (16) of the subset (18) of battery cells from a second statistical parameter. Moreover, the method comprises obtaining third data (D3) indicative of a statistical distance measure per battery cell (16) of the subset (18) of battery cells, based on the first data (D1) and based on the second data (D2). Furthermore, the method comprises providing fourth data (D4) indicative of an anomaly for one or more battery cells (16) associated with the statistical distance measure. The disclosure is also directed to a method for controlling a battery assembly (12) for a vehicle (12). Moreover, the disclosure relates to a data processing apparatus (24), a computer program (32), a computer-readable storage medium (30), a vehicle (10), and to a use of a statistical distance measure for detecting an anomaly in one or more battery cells (16).

Fig. 1

EP 4 733 789 A1

## Description

TECHNICAL FIELD

The present disclosure relates to a method for detecting an anomaly in one or more battery cells of a plurality of battery cells for a vehicle and to a method for controlling a battery assembly for a vehicle.

The present disclosure also relates to a corresponding data processing apparatus, a computer program and to a computer-readable storage medium.

Moreover, the present disclosure is directed to a vehicle comprising the data processing apparatus as well as to a use.

BACKGROUND ART

During use of a vehicle comprising a battery assembly with a plurality of battery cells, the battery assembly provides energy or power to one or more components of the vehicle. Alternatively, the battery assembly is charged such that it can provide energy or power to one or more components of the vehicle at a later point in time. In any case, the battery assembly needs to be operated in a reliable and safe manner in order to make the one or more components of the vehicle work reliably and safely. In an example, the battery assembly forms part of a traction battery or is a traction battery. This means that the energy stored in the battery assembly and the one or more battery cells comprised by the battery assembly is used for driving the vehicle.

SUMMARY

It is an objective of the present disclosure to further improve reliability and/or safety of a battery assembly for a vehicle.

The problem is at least partially solved or alleviated by the subject matter of the independent claims of the present disclosure, wherein further examples are incorporated in the dependent claims.

According to a first aspect, there is provided a method for detecting an anomaly in one or more battery cells of a plurality of battery cells for a vehicle. The method comprises:

- obtaining first data indicative of a deviation of a state of charge per battery cell of at least a subset of the plurality of battery cells from a first statistical parameter, the first statistical parameter being descriptive of a collective state of charge for the subset of battery cells,
- obtaining second data indicative of a deviation of a state of health per battery cell of the subset of battery cells from a second statistical parameter, the second statistical parameter descriptive of a collective state of health for the subset of battery cells,
- obtaining third data indicative of a statistical distance measure per battery cell of the subset of battery cells, based on the first data and based on the second data, and
- comparing the third data to a predefined distance threshold and, based on the comparing, providing fourth data indicative of an anomaly for the one or more battery cells associated with a statistical distance measure exceeding the predefined distance threshold or being smaller than the predefined distance threshold.

An anomaly in the one or more battery cells may be understood as a deviation from a norm and/or from an expected state of the battery cell. This may affect an electric performance of the battery cell. Usually, the battery assembly comprises a plurality of battery cells. A subset of battery cells may therefore be understood as a portion of at least two battery cells of the battery assembly. Also all battery cells of the battery assembly may be considered as a subset. The collective state of charge for the subset of battery cells is to be understood as a state of charge characterizing the subset of battery cells, i.e. a plurality of battery cells. Thus, the first data is indicative of a deviation and/or a difference of the state of charge of an individual battery cell with respect to the state of charge of the subset of battery cells. Likewise, the collective state of health for the subset of battery cells is to be understood as a state of health characterizing the subset of battery cells, i.e. a plurality of battery cells. Thus, the second data is indicative of a deviation and/or a difference of the state of health of an individual battery cell with respect to the state of health of the subset of battery cells. The statistical distance measure expresses the deviation and/or the difference of the state of charge of the individual battery cell as well as the deviation and/or the difference of the state of health of the individual battery cell with respect to the state of charge and the overall state of health of the subset of battery cells, respectively. This means that both the state of charge and the state of health of the individual battery cells are considered when obtaining the statistical distance measure. Considering the state of charge and the state of health and using a collective state of charge and a collective state of health allows a particularly accurate identification of anomalous battery cells. The fourth data is provided depending on the statistical distance measure exceeding the predefined distance threshold or being inferior to the predefined distance threshold. Comparing the statistical distance measure to a predefined threshold is a reliable method of identifying a battery cell that shows an anomaly. Based thereon, reliability and safety of the battery assembly comprising the battery cell that shows an anomaly may be enhanced.

In an example, the statistical distance measure is configured to account for statistical covariance between the first data and the second data. In an example, the statistical measure is a statistical covariance measure. The statistical covariance is a measure of the joint variability of the first data and the second data. Thus, the covariance expresses a degree of correlation between the first data and the second data. The statistical distance measure accounting for the statistical covariance between the first data and the second data has the effect that comparatively large deviations in state of charge and/or in state of health from the collective state of charge or the collective state of health, respectively, may not be regarded as an anomaly as long as the respective deviations can be explained by a correlation of the state of charge and the state of health. However, even small deviations in state of charge and/or state of health from the collective state of charge or the collective state of health, respectively, may be regarded as an anomaly as soon as even small deviations cannot be explained by a correlation of the state of charge and the state of health. Thus, applying a statistical distance measure accounting for a covariance between the first data and the second data is a way of specifically tailoring the statistical distance measure to naturally occurring deviations in the first data and in the second data. Consequently, an anomaly may be detected in a very reliable manner.

In an example, the statistical distance measure is a Mahalanobis-type distance. A kind of a Mahalanobis-type distance is the Mahalanobis distance. When calculating the Mahalanobis distance for a specific battery cell, the first data indicative of a deviation of the state of charge of the specific battery cell from the collective state of charge of the subset of battery cells is a first entry of a column vector $\overleftarrow{x}$. The second data indicative of a deviation of the state of health of the specific battery cell from the collective state of health of the subset of battery cells is a second entry of the column vector $\overleftarrow{x}$. The Mahalanobis distance $d_M$ is provided for the specific battery cell by the formula $d_M = \sqrt{\vec{x}^T S^{-1} \vec{x}}$, wherein $S^{-1}$ is the inverse of the commonly known covariance matrix. The covariance matrix is calculated from a matrix having the deviations of the states of charges of all battery cells of the battery assembly being determined for anomalies in the first column and the deviations of the states of health of all battery cells of the battery assembly being determined for anomalies in the second column. In case the Mahalanobis distance of a battery cell exceeds a predefined statistical distance threshold, the respective battery cell can reliably be identified as comprising an anomaly. Other Mahalanobis-type distances include the Bregman Divergence and the principal component analysis (PCA).

In another example, singular value decomposition may be used to derive third data indicative of a statistical distance measure per battery cell of the subset of battery cells. Singular values obtained from singular value decomposition may be interpreted as encoding a magnitude of a semiaxis of an ellipsoid encapsulating data points having coordinates being based on the first data and based on the second data. Singular vectors obtained from singular value decomposition may be interpreted as encoding a direction of the semiaxis of the ellipsoid encapsulating data points having coordinates being based on the first data and based on the second data.

In an example, the first statistical parameter is a measure of central tendency. Additionally or alternatively, the second statistical parameter is a measure of central tendency. In an example, the first statistical parameter is a mean value, a median or a mode. Similarly, the second statistical parameter may be a mean value, a median or a mode. The first statistical parameter being a measure of central tendency of the states of charge of the battery cells of the subset of battery cells has the effect that the deviation in state of charge of a battery cell is determined in relation to a statistically representative measure of the state of charge of its corresponding subset of battery cells. The second statistical parameter being a measure of central tendency of the states of health of the battery cells of the subset of battery cells has the effect that the deviation in state of health of a battery cell is determined in relation to a statistically representative measure of the state of health of its corresponding subset of battery cells. Both of this makes the resulting statistical distance measure particularly robust and reliable because outliers of the battery cells in terms of state of charge and/or state of health may not significantly influence the first statistical parameter and/or the second statistical parameter.

In an example, the state of charge is relatable to a ratio between an amount of electrical energy currently stored in a battery cell and a maximum amount of electrical energy storable in the battery cell. In other words, the state of charge is associable to a ratio between an amount of electrical energy currently stored in a battery cell and a maximum amount of electrical energy storable in the battery cell. In an example, the state of charge may be related or associated to a ratio between an amount of electrical energy currently stored in a battery cell and a maximum amount of electrical energy storable in the battery cell. In this context, the maximum amount of electrical energy storable in the battery cell is an amount of electrical energy that can actually be stored in the battery cell under practical conditions. The state of charge may typically be indicated by a percentage between 0 and 100 %. Thus, the state of charge provides a realistic indication of how much of an actual energy storing capacitance of a battery cell is currently being used.

In an example, the state of health is described by one or more of

- a capacitance of the associated battery cell,
- an internal electrical resistance of the associated battery cell,
- a voltage providable by the associated battery cell,
- a self-discharge indicator of the associated battery cell,
- an indicator of an ability of the associated battery cell to accept a charge,

- a number of charging cycles of the associated battery cell,
- a number of discharging cycles of the associated battery cell,
- an age of the associated battery cell,
- a temperature of the associated battery cell,
- a total energy with which the associated battery cell is chargeable, and
- a total energy dischargeable from the associated battery cell.

The state of health of the battery cell may be a maximum amount of electric energy storable in the battery cell relative to a nominal amount of electric energy storable in the battery cell. The nominal amount of electric energy storable in the battery cell is an amount that is usually only reached under ideal conditions and when the battery cell has not been subject to any aging, yet. Due to the fact that it may be difficult to determine a true state of health of a battery cell, the above-mentioned indicators may be used to describe the state of health of the battery cell. The above-mentioned indicators may be determined in a simple and reliable manner. Thus, a reliable indication of a state of health of a battery cell may be provided with simple but accurate means.

In an example, the subset of battery cells forms part of the same module of the battery assembly. This means that all battery cells of the subset of battery cells may be comprised in the same module of the battery assembly. The subset of battery cells may comprise some battery cells of the same module of the battery assembly or all battery cells of the same module of the battery assembly. A module of the battery assembly may be a subdivision of the battery assembly. The module of the battery assembly may be electrically connected in a way that the module forms a separate unit of the battery assembly, i.e. the module may be charged and/or discharged separately from other modules of the battery assembly and/or may be disconnectable from the remaining battery assembly when other modules of the remaining battery assembly are being charged and/or discharged. Also, all battery cells of a module of the battery assembly may be charged and/or discharged at the same time. Thus, assessing an anomaly in one or more battery cells in respect of other battery cells from the same module of the battery assembly provides a meaningful comparative group of battery cells. This enables the fourth data to provide an accurate indication of an anomaly being present in a battery cell of battery assembly for a vehicle.

According to a second aspect, there is provided a method for controlling a battery assembly for a vehicle. The method comprises:

- detecting an anomaly in one or more battery cells of the battery assembly using the method of the first aspect, and
- causing an anomaly mitigation measure in respect of the one or more battery cells.

The anomaly mitigation measure may involve providing a warning and/or a recommendation to a driver and/or a passenger of the vehicle to have the battery cell and/or the subset of battery cells and/or the module of the battery assembly that comprises an anomaly replaced and/or repaired. Additionally or alternatively, the anomaly mitigation measure may also involve to not fully charge the battery cell and/or the subset of battery cells and/or the module of the battery assembly that shows an anomaly during charging of the battery assembly. In a special case of not fully charging the battery cell, the battery cell may not be charged at all. Further additionally or alternatively, the anomaly mitigation measure may involve electrically insulating the battery cell and/or the subset of battery cells and/or the module of the battery assembly that comprises the anomaly from the remaining battery cells of the battery assembly. Causing the anomaly mitigation measure prevents the anomaly from getting worse and from potentially affecting further battery cells, subsets of battery cells and/or battery modules. This has the effect that the anomaly is kept in a confined area and/or a confined state within the battery assembly, which minimizes damage to the battery assembly.

The method of the first and/or of the second aspect may be at least partly computer-implemented, and may be implemented in software or in hardware, or in software and hardware. Further, the methods may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a third aspect, there is provided a data processing apparatus comprising means for carrying out the method of the first aspect and/or the method of the second aspect. Using such a data processing apparatus, fourth data indicative of an anomaly for one or more battery cells associated with a statistical distance measure may be provided in a reliable manner. Particularly, the data processing apparatus allows obtaining first data indicative of a deviation of the state of charge per battery cell of at least a subset of the battery cells from a first statistical parameter. The first statistical parameter is descriptive of a collective state of charge for the subset of battery cells. Moreover, the data processing apparatus may allow obtaining second data indicative of a deviation of the state of health per battery cell of the subset of battery cells from a second statistical parameter. The second statistical parameter is descriptive of a collective state of health for the subset of battery cells. Furthermore, the data processing apparatus may allow obtaining third data indicative of a statistical distance measure per battery cell of the subset of battery cells based on the first data and based on the second data. Finally, the data processing apparatus may be configured to compare the third data to a predefined distance threshold and to provide fourth data indicative of an anomaly for one or more battery cells based on the comparing. The fourth data may be provided if the third data exceeds a predefined distance threshold or if the third data is smaller than a predefined distance threshold. The statistical distance measure expresses the deviation and/or the difference of the state of charge of the individual battery cell as well as the deviation and/or the difference of the state of health of the individual battery cell with respect to the collective state of charge or the collective state of health of the subset of battery cells, respectively. This means that both the state of charge and the state of health of the individual battery cells are considered when obtaining the statistical distance measure. Considering these two parameters allows a particularly accurate identification of anomalous battery cells. The fourth data is provided depending on the statistical distance measure exceeding the predefined distance threshold or being inferior to the predefined distance threshold. Comparing the statistical distance measure to a predefined threshold is a reliable method of identifying a battery cell that shows an anomaly. In case the data processing apparatus comprises means for carrying out the method of the second aspect, the data processing apparatus is additionally configured to cause an anomaly mitigation measure in respect of the one or more battery cells for which an anomaly has been detected. The example anomaly mitigation measures as mentioned in connection with the second aspect also apply here. Causing the anomaly mitigation measure prevents the anomaly from getting worse and from potentially affecting further battery cells, subsets of battery cells and/or battery modules. This has the effect that the anomaly is kept in a confined area and/or a confined state within the battery assembly, which minimizes damage to the battery assembly.

According to a fourth aspect, there is provided a computer program comprising instructions which, when the computer program is executed by a computer, cause the computer to carry out the method of the first aspect and/or the method of the second aspect. Using such a computer program, fourth data indicative of an anomaly for one or more battery cells associated with a statistical distance measure may be provided in a reliable manner. Particularly, the computer program allows obtaining first data indicative of a deviation of the state of charge per battery cell of at least a subset of the battery cells from a first statistical parameter. The first statistical parameter is descriptive of a collective state of charge for the subset of battery cells. Moreover, the computer program may allow obtaining second data indicative of a deviation of the state of health per battery cell of the subset of battery cells from a second statistical parameter. The second statistical parameter is descriptive of a collective state of health for the subset of battery cells. Furthermore, the computer program may allow obtaining third data indicative of a statistical distance measure per battery cell of the subset of battery cells based on the first data and based on the second data. Finally, the computer program may be configured to compare the third data to a predefined distance threshold and to provide fourth data indicative of an anomaly for one or more battery cells based on the comparing. The fourth data may be provided if the third data exceeds a predefined distance threshold or if the third data is smaller than a predefined distance threshold. The statistical distance measure expresses the deviation and/or the difference of the state of charge of the individual battery cell as well as the deviation and/or the difference of the state of health of the individual battery cell with respect to the collective state of charge and the collective state of health of the subset of battery cells, respectively. This means that both the state of charge and the state of health of the individual battery cells are considered when obtaining the statistical distance measure. Considering these two parameters allows a particularly accurate identification of anomalous battery cells. The fourth data is provided depending on the statistical distance measure exceeding the predefined distance threshold or being inferior to the predefined distance threshold. Comparing the statistical distance measure to a predefined threshold is a reliable method of identifying a battery cell that shows an anomaly. In case the computer program comprises instructions which, when the computer program is executed by a computer, cause the computer to carry out the method of the second aspect, the computer program is additionally configured to cause an anomaly mitigation measure in respect of the one or more battery cells for which an anomaly has been detected. The example anomaly mitigation measures as mentioned in connection with the second aspect also apply here. Causing the anomaly mitigation measure prevents the anomaly from getting worse and from potentially affecting further battery cells, subsets of battery cells and/or battery modules. This has the effect that the anomaly is kept in a confined area and/or a confined state within the battery assembly, which minimizes damage to the battery assembly.

According to a fifth aspect, there is provided a computer-readable storage medium comprising instructions which, when executed by a computer, cause the computer to carry out the method of the first aspect and/or the method of the second aspect. Using such a computer-readable storage medium, fourth data indicative of an anomaly for one or more battery cells associated with a statistical distance measure may be provided in a reliable manner. Particularly, the computer-readable storage medium allows obtaining first data indicative of a deviation of the state of charge per battery cell of at least a subset of the battery cells from a first statistical parameter. The first statistical parameter is descriptive of a collective state of charge for the subset of battery cells. Moreover, the computer-readable storage medium may allow obtaining second data indicative of a deviation of the state of health per battery cell of the subset of battery cells from a second statistical parameter. The second statistical parameter is descriptive of a collective state of health for the subset of battery cells. Furthermore, the computer-readable storage medium may allow obtaining third data indicative of a statistical distance measure per battery cell of the subset of battery cells based on the first data and based on the second data. Finally, the computer-readable storage medium may be configured to compare the third data to a predefined distance threshold and to provide fourth data indicative of an anomaly for one or more battery cells based on the comparing. The fourth data may be provided if the third data exceeds a predefined distance threshold or if the third data is smaller than a predefined distance threshold. The statistical distance measure expresses the deviation and/or the difference of the state of charge of the individual battery cell as well as the deviation and/or the difference of the state of health of the individual battery cell with respect to the collective state of charge and the collective state of health of the subset of battery cells, respectively. This means that both the state of charge and the state of health of the individual battery cells are considered when obtaining the statistical distance measure. Considering these two parameters allows a particularly accurate identification of anomalous battery cells. The fourth data is provided depending on the statistical distance measure exceeding the predefined distance threshold or being inferior to the predefined distance threshold. Comparing the statistical distance measure to a predefined threshold is a reliable method of identifying a battery cell that shows an anomaly. In case the computer-readable storage medium comprises instructions which, when executed by a computer, cause the computer to carry out the method of the first second aspect, the computer-readable storage medium is additionally configured to cause an anomaly mitigation measure in respect of the one or more battery cells for which an anomaly has been detected. The example anomaly mitigation measures as mentioned in connection with the second aspect also apply here. Causing the anomaly mitigation measure prevents the anomaly from getting worse and from potentially affecting further battery cells, subsets of battery cells and/or battery modules. This has the effect that the anomaly is kept in a confined area and/or a confined state within the battery assembly, which minimizes damage to the battery assembly.

According to a sixth aspect, there is provided a vehicle comprising a data processing apparatus of the third aspect. In such a vehicle, fourth data indicative of an anomaly for one or more battery cells associated with a statistical distance measure may be provided in a reliable manner. Moreover, in case the data processing apparatus according to the third aspect comprises means for carrying out the method of the second aspect, the example anomaly mitigation measures as mentioned in connection with the second aspect also apply here. Causing the anomaly mitigation measure prevents the anomaly from getting worse and from potentially affecting further battery cells, subsets of battery cells and/or battery modules. This has the effect that the anomaly is kept in a confined area and/or a confined state within the battery assembly, which minimizes damage to the battery assembly.

According to a seventh aspect, there is provided a use of a statistical distance measure for detecting an anomaly in one or more battery cells of a battery assembly for a vehicle. As has been mentioned before, a statistical distance measure is an objective measure for detecting an anomaly in a plurality of battery cells since the statistical distance measure may be compared to a predefined statistical distance threshold in a simple and reliable manner.

In an example, the statistical distance measure is a Mahalanobis-type distance. A kind of a Mahalanobis-type distance is the Mahalanobis distance. In case the Mahalanobis distance of a battery cell exceeds a predefined statistical distance threshold, the respective battery cell can reliably be identified as comprising an anomaly. The explanations provided for the Mahalanobis distance in connection with the first aspect of the present disclosure also apply here. Other Mahalanobis-type distances include the Bregman Divergence and the principal component analysis (PCA).

In another example, singular value decomposition may be used to derive the statistical distance measure. The explanations provided for the singular value decomposition in connection with the first aspect of the present disclosure also apply here.

In an example, the statistical distance measure is obtained based on first data indicative of a deviation of a state of charge per battery cell of at least a subset of the battery cells from a first statistical parameter. The first statistical parameter is descriptive of a collective state of charge for the subset of battery cells. Additionally or alternatively, the statistical distance measure is obtained based on second data indicative of a deviation of a state of health per battery cell of the subset of battery cells from a second statistical parameter. The second statistical parameter is descriptive of a collective state of health for the subset of battery cells. This means that both the state of charge and the state of health of the individual battery cells are considered when obtaining the statistical distance measure. Considering these two parameters allows a particularly accurate identification of anomalous battery cells.

It should be noted that the above examples may be combined with each other irrespective of the aspect involved.

These and other aspects of the present disclosure will become apparent from and elucidated with reference to the examples described hereinafter.

BRIEF DESCRIPTION OF DRAWINGS

Examples of the disclosure will be described in the following with reference to the following drawings.

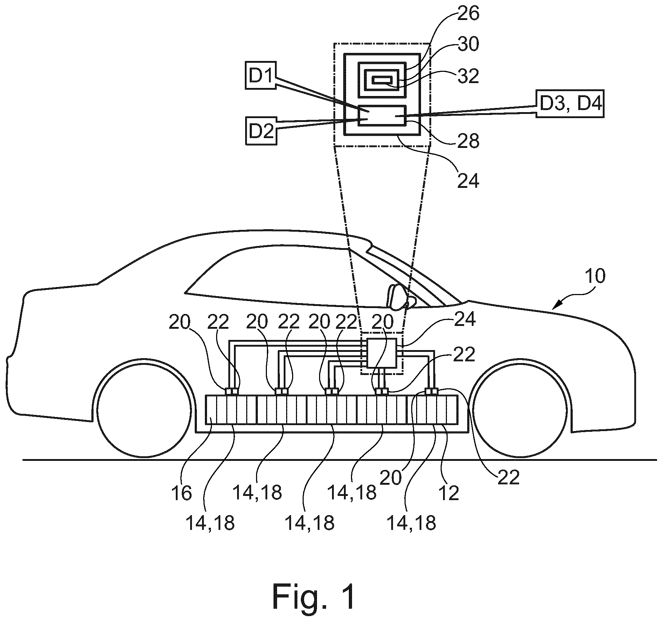

Figure 1 shows a vehicle according to the present disclosure comprising a data processing apparatus according to the present disclosure comprising means for carrying out a first method according to the present disclosure for controlling a battery assembly for the vehicle and comprising means for carrying out a second method according to the present disclosure for detecting an anomaly in one or more battery cells of a battery assembly for the vehicle,

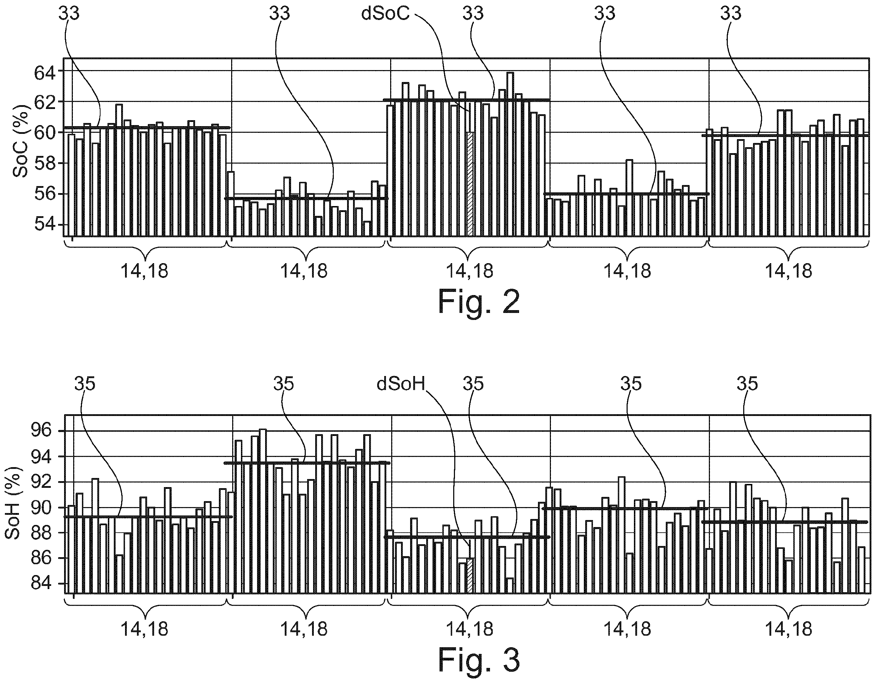

Figure 2 shows a bar chart of example states of charge of all battery cells of the battery assembly of the vehicle of Figure 1,

Figure 3 shows a bar chart of example states of health of all battery cells of the battery assembly of the vehicle of Figure 1,

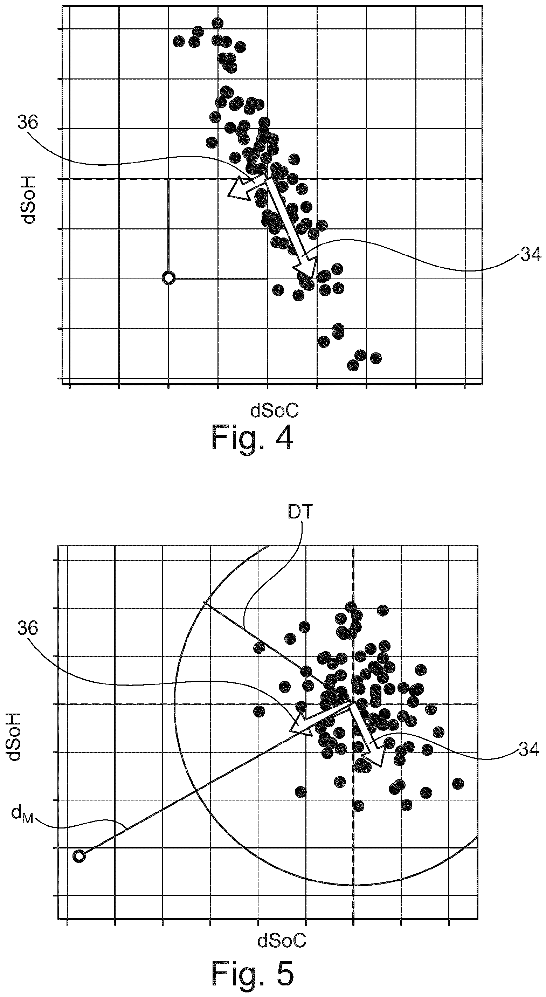

Figure 4 shows a diagram representing the deviations in state of charge from a first statistical parameter and the deviations in state of health from a second statistical parameter of the battery cells of the battery assembly of the vehicle of Figure 1, wherein each point in the diagram is associated with one battery cell,

Figure 5 shows a diagram representing the deviations in state of charge from a first statistical parameter and the deviations in state of health from a second statistical parameter of the battery cells of the battery assembly of the vehicle of Figure 1, wherein a first vector indicating a direction of largest variance in the data and a second vector perpendicular to the first vector have been normalized, and wherein again each point in the diagram is associated with one battery cell, and

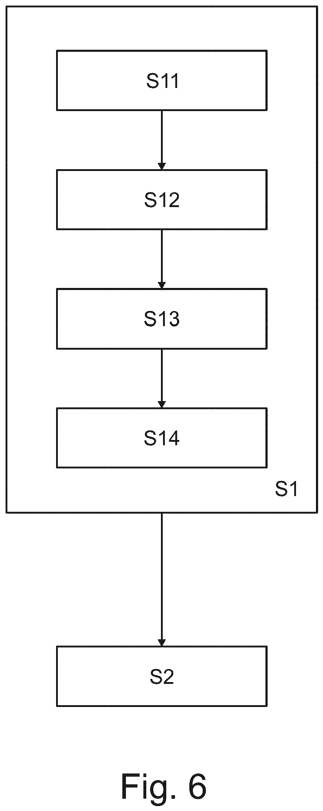

Figure 6 shows steps of the first method according to the present disclosure for controlling a battery assembly for a vehicle and steps of the second method according to the present disclosure for detecting an anomaly in one or more battery cells of a battery assembly for a vehicle.

DETAILED DESCRIPTION

The Figures are merely schematic representations and serve only to illustrate examples of the disclosure. Identical or equivalent elements are in principle provided with the same reference signs.

Figure 1 shows a vehicle 10.

The vehicle 10 comprises a battery assembly 12, which is often called a battery pack. The battery assembly 12 of the vehicle 10 of Figure 1 is a traction battery.

The battery assembly 12 comprises a plurality of battery modules 14. In the present example, battery assembly 12 comprises five battery modules 14.

Each battery module 14 comprises twenty battery cells 16, of which only five per battery module 14 are shown in Figure 1 and of which only one is marked by a reference sign for reasons of ease of representation.

A plurality of battery cells 16 forms a subset 18 of battery cells. In an example, a subset 18 of battery cells may be comprised of any battery cells 16 across the battery assembly 12. In another example, a subset 18 of battery cells is limited to battery cells 16 of the same battery module 14. In this case, a subset 18 of battery cells may comprise only some battery cells 16 of the same battery module 14 or all battery cells 16 of the same battery module 14.

In the present example, which will particularly be explained reference to Figures 2 to 5, a subset 18 of battery cells 16 is formed by all battery cells 16 of a battery module 14. Thus, all five battery modules 14 of the battery assembly 12 of the vehicle 10 of Figure 1 each form a subset 18 of battery cells.

The vehicle 10 further comprises means 20 for detecting a state of charge of each battery cell 16 of each battery module 14.

Additionally, the vehicle 10 comprises means 22 for detecting a state of health of each battery cell 16 of each battery module 14.

The vehicle 10 also comprises a data processing apparatus 24.

The data processing apparatus 24 is communicatively connected to each means 20 for detecting a state of charge of each battery cell 16 of each battery module 14.

The data processing apparatus 24 is also communicatively connected to each means 22 for detecting a state of health of each battery cell 16 of each battery module 14.

The data processing apparatus 24 comprises a data storage unit 26 and a data processing unit 28.

The data storage unit 26 comprises a computer-readable storage medium 30.

On the computer-readable storage medium 30, there is provided a computer program 32.

The computer program 32 and, thus, also the computer-readable storage medium 30, comprise instructions which, when executed by the data processing unit 28, or, more generally speaking, a computer, cause the computer or the data processing unit 28 to carry out a first method for controlling a battery assembly 12 of a vehicle 10 and a second method for detecting an anomaly in one or more battery cells 16 of a battery assembly 12 for a vehicle 10.

Consequently, the data storage unit 26 and the data processing unit 28 form means for carrying out the first method for controlling a battery assembly 12 of a vehicle 10 and means for carrying out the second method for detecting an anomaly in one or more battery cells 16 of a battery assembly 12 for a vehicle 10.

The steps of the first method are illustrated in Figure 6.

As a first step S 1, the first method comprises executing the second method for detecting an anomaly in one or more battery cells 16 of a battery assembly 12 for a vehicle 10. The second method will be explained in more detail further below.

As a second step S2, the first method comprises causing an anomaly mitigation measure in respect of the one or more battery cells 16 for which an anomaly has been detected.

The anomaly mitigation measure may comprise a warning and/or a recommendation to a driver and/or a passenger of the vehicle 10 comprising an anomalous battery cell and/or the subset 18 of battery cells that comprises the anomalous battery cell 16 and/or the entire battery module 14 that comprises the anomalous battery cell 16. The warning and/or recommendation may suggest replacement and/or repair in a workshop.

Additionally or alternatively, the anomaly mitigation measure may comprise not fully charging an anomalous battery cell 16 and/or the subset 18 of battery cells that comprises the anomalous battery cell 16 and/or the entire battery module 14 that comprises the anomalous battery cell 16.

It is also conceivable that the anomaly mitigation measure comprises electrically insulating an anomalous battery cell 16 and/or the subset 18 of battery cells that comprises the anomalous battery cell 16 and/or the entire battery module 14 that comprises the anomalous battery cell 16 from an electric drivetrain of the vehicle 10, for example, by means of an electric switch.

The second method for detecting an anomaly in one or more battery cells 16 of a battery assembly 12 for a vehicle 10 comprises four steps.

In a first step S11 of the second method, the data processing apparatus 24 obtains first data D 1 indicative of a deviation dSoC of the state of charge per battery cell 16 of at least a subset 18 of the battery cells from a first statistical parameter. The first statistical parameter is descriptive of a collective state of charge for the subset 18 of battery cells.

For this first step S 11, the data processing apparatus 24 obtains a state of charge of all battery cells 16 of a subset 18 of battery cells. As already mentioned above, in the present example, a subset 18 of battery cells corresponds to a battery module 14 of the battery assembly 12. In the present example, the data processing apparatus 24 obtains states of charge of all battery cells 16 of all battery modules 14 of the battery assembly 12 through the means 20 for detecting a state of charge. The result of this can be seen from the bar chart in Figure 2, which indicates a state of charge per battery cell 16 of all battery cells 16 of the battery assembly 12.

In this context, the state of charge is a ratio between an amount of electrical energy currently stored in a battery cell 16 and the maximum amount of electrical energy storable in the battery cell 16 under practical conditions. Practical conditions may particularly involve that the battery cell 16 has already been subject to an aging process, which reduces the maximum amount of electrical energy storable in the battery cell 16.

Still for the first step S 11, the data processing apparatus 24 determines a measure of central tendency of the states of charge of the battery cells 16 of each battery module 14.

In principle, the average can be a mean and/or a median of the states of charge of the battery cells 16. In the present case, the median state of charge 33 per battery module 14 is determined and represented in the bar chart of Figure 2 as a horizontal line spanning over all bars associated with battery cells 16 of a battery module 14.

Still for the first step S 11, the data processing apparatus 24 determines a deviation dSoC in state of charge of each battery cell 16 from the determined measure of central tendency, i.e. the median, of the state of charge per battery module 14. Such a deviation is the difference between the state of charge and the median. An example is illustrated in the bar chart of Figure 2 as a thin vertical line.

In a second step S12 of the second method, the data processing apparatus 24 obtains second data D2 indicative of a deviation dSoH of the state of health per battery cell of at least a subset 18 of the battery cells from a second statistical parameter. The second statistical parameter is descriptive of a collective state of health for the subset 18 of battery cells.

For the second step S12, the data processing apparatus 24 obtains a state of health of all battery cells 16 of a subset 18 of battery cells. As already mentioned above, in the present example, a subset 18 of battery cells corresponds to a battery module 14. In the present example, the data processing apparatus 24 obtains states of health of all battery cells 16 of all battery modules 14 through the means 22 for detecting a state of health. The result of this can be seen from the bar chart in Figure 3, which indicates a state of health per battery cell 16 of all battery cells 16 of the battery assembly 12.

In this context, the state of health is a ratio between a current maximum amount of electrical energy storable in an aged battery cell 16 and the maximum amount of electrical energy storable in a new battery cell 16. The maximum amount of electrical energy storable in a new battery cell 16 is often referred to as a nominal capacitance of a battery cell 16.

Since it is difficult to directly measure a true state of health of a battery cell 16, the means 22 for detecting a state of health may determine one or more of the following parameters of the battery cell 16 to indicate its state of health:

- a capacitance of the associated battery cell 16,
- an internal electrical resistance of the associated battery cell 16,
- a voltage providable by the associated battery cell 16,

- a self-discharge indicator of the associated battery cell 16,
- an indicator of an ability of the associated battery cell 16 to accept a charge,
- a number of charging cycles of the associated battery cell 16,
- a number of discharging cycles of the associated battery cell 16,
- an age of the associated battery cell 16,
- a temperature of the associated battery cell 16,
- a total energy with which the associated battery 16 cell is chargeable, and
- a total energy dischargeable from the associated battery cell 16.

Still for the second step S 12, the data processing apparatus 24 determines a measure of central tendency of the states of health of the battery cells 16 of each battery module 14.

In principle, the measure of central tendency can be a mean and/or a median of the states of health of the battery cells 16. In the present case, the median 35 state of health per battery module 14 is determined and represented in the bar chart of Figure 3 as a horizontal line spanning over all bars associated with battery cells 16 of a battery module 14.

Still for the second step S12, the data processing apparatus 24 determines a deviation dSoH in state of health of each battery cell 16 from the determined measure of central tendency, i.e. the median, of the state of health per battery module 14. An example is illustrated in Figure 3 as a thin vertical line.

In a third step S13 of the second method, the data processing apparatus 24 obtains third data D3 indicative of a statistical distance measure per battery cell 16 of the subset 18 of battery cells based on the first data D1 and based on the second data D2.

The statistical distance measure used herein accounts for a statistical covariance between a deviation dSoC of the state of charge per battery cell 16 from a median 33 state of charge of a battery module 14 and a deviation dSoH of the state of health per battery cell 16 from a median 35 state of health of the battery module 14.

In Figure 4, the deviations dSoC of the state of charge and the deviations dSoH of the state of health are graphically illustrated for each of the battery cells.

In the present example, the statistical distance measure is a Mahalanobis distance $d_M$.

In the present case, the Mahalanobis distance $d_M$ is calculated for each battery cell 16 of the battery assembly 12. The first data D1 indicative of a deviation dSoC of the state of charge of a specific battery cell 16 from the median 33 state of charge of the battery module 14 forms a first entry of a column vector $\overleftarrow{x}$. The second data D2 indicative of a deviation dSoH of the state of health of the specific battery cell 16 from the median 35 state of health of the battery module 14 forms a second entry of the column vector $\overleftarrow{x}$.

The Mahalanobis distance $d_M$ for each battery cell 16 is provided by the formula $d_M = \sqrt{\vec{x}^T S^{-1} \vec{x}}$, wherein $S^{-1}$ is the inverse of the commonly known covariance matrix. The covariance matrix is calculated from a matrix having the deviations dSoC of states of charge of all battery cells 16 of the battery assembly 12 in a first column and the deviations dSoH of states of health of all battery cells 16 of the battery assembly 12 in a second column. This results in an inverse $S^{-1}$ of the covariance matrix being in the dimension of 2x2. In conjunction with the dimension of $\overleftarrow{x}^T$ being 1x2 and the dimension of $\overleftarrow{x}$ being 2x1, this results in a scalar 1x1 value for the Mahalanobis distance $d_M$ of an individual battery cell 16.

In a fourth step S14 of the second method, the Mahalanobis distance $d_M$ of an individual battery cell 16 is compared to a predefined distance threshold DT.

In case the Mahalanobis distance $d_M$ of a battery cell 16 exceeds a predefined statistical distance threshold DT, which is also a scalar value, the respective battery cell 16 is identified as comprising an anomaly and fourth data D4 indicative of the anomaly is provided by the data processing apparatus 24.

In case the Mahalanobis distance $d_M$ of a battery cell 16 in equal or inferior to the predefined statistical distance threshold DT, the respective battery cell 16 is deemed to exhibit normal and/or expected electrical properties by the data processing apparatus 24.

For an even better understanding, the mathematical considerations from above will be explained in a graphic manner with respect to Figures 4 and 5.

In Figure 4, the deviation dSoC in state of charge of a battery cell 16 is represented on the x-axis and the deviation dSoH in state of health of a battery cell 16 is represented on the y-axis. Each data point in the diagram of Figure 4 corresponds to one battery cell 16 of the battery assembly 12. The location of each data point in the diagram of Figure 4 is defined by the deviation dSoC in state of charge and the deviation dSoH in state of health of the corresponding battery cell 16 from the median 33 state of charge and from the median 35 state of health of the battery module 14 comprising the corresponding battery cell 16, respectively.

In general, it can be observed in the diagram of Figure 4 that the deviation dSoC in state of charge and the deviation dSoH in state of health of the battery cells 16 of the battery assembly 12 show a negative covariance.

A first vector 34 pointing to the bottom right of the diagram indicates a direction of largest the variance in the data. A second vector 36 is points in a direction perpendicular to the first vector 34. A magnitude of the first vector 34 and a magnitude of the second vector 36 indicate the standard deviation in the data along a direction of the first vector 34 and in a direction of the second vector 36, respectively.

Figure 5 shows in principle the same type of diagram as in Figure 4. However, the x-axis indicating a deviation dSoC in state of charge and the y-axis indicating a deviation dSoH in state of health have been linearly transformed such that the first vector 34 and the second vector 36 are normalized. This means that a length of the first vector 34 and a length of the second vector 36 equals one length unit.

The predefined statistical distance threshold DT is drawn in by a circle around the origin in the diagram of Figure 5.

It can be observed that one data point lies outside the circle indicating the statistical distance threshold DT. All other data points lie inside the circle.

Hence, the Mahalanobis distance $d_M$ of the battery cell 16 corresponding to said data point exceeds the predefined statistical distance threshold DT.

The respective battery cell 16 can therefore be flagged or determined as comprising an anomaly and fourth data D4 indicative of the anomaly is provided by the data processing apparatus 24 for the respective battery cell 16.

In the above illustration of an example of the present disclosure, a statistical distance measure for detecting an anomaly in one or more battery cells 16 of a battery assembly 12 for a vehicle 10 has been used.

In the presented use, the statistical distance measure is a Mahalanobis distance $d_M$ as has been explained above.

It is noted that the steps S1, S2 of the first method and the steps S11, S12, S13, S14 of the second method may be executed using a data processing apparatus 24 located in the vehicle 10 as illustrated in Figure 1. However, this is just one option. Alternatively, the steps S1, S2 of the first method and the steps S 11, S12, S13, S14 of the second method may be executed using a data processing apparatus 24 provided as a remote server. In this alternative, the data processing apparatus 24 does not form part of the vehicle 10 but is communicatively connected to the vehicle 10, more specifically at least to the means for detecting a state of charge and the means for detecting a state of health. According to still another alternative, some of the steps S1, S2 of the first method and/or some of the steps S 11, S12, S13, S14 of the second method may be executed by a data processing apparatus located in the vehicle 10 and the remaining steps may be executed by a data processing apparatus provided as a remote server. This means that the execution of the steps S1, S2 of the first method and/or the steps S11, S12, S13, S14 of the second method may be distributed over these two data processing apparatuses.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

LIST OF REFERENCE SIGNS

| | |
|---|---|
| 10 | vehicle |
| 12 | battery assembly |
| 14 | battery module |
| 16 | battery cell |
| 18 | subset of battery cells |
| 20 | means for detecting a state of charge |
| 22 | means for detecting a state of health |
| 24 | data processing apparatus |
| 26 | data storage unit |
| 28 | data processing unit |
| 30 | computer-readable storage medium |
| 32 | computer program |

33    median state of charge of a subset of battery cells
34    first vector
35    median state of health of a subset of battery cells
36    second vector

DT     distance threshold
$d_M$    Mahalanobis distance
dSoC   deviation of a state of charge of a battery cell from a first statistical parameter
dSoH   deviation of a state of health of a battery cell from a second statistical parameter

D1    first data
D2    second data
D3    third data
D4    fourth data
S1    first step of first method

S2    second step of first method
S11   first step of second method
S12   second step of second method
S13   third step of second method
S14   fourth step of second method

**Claims**

1.   A method for detecting an anomaly in one or more battery cells (16) of a plurality of battery cells (16) for a vehicle (10), the method comprising:

- obtaining first data (D1) indicative of a deviation (dSoC) of a state of charge per battery cell (16) of at least a subset (18) of the plurality of battery cells (16) from a first statistical parameter, the first statistical parameter being descriptive of a collective state of charge for the subset (18) of battery cells,
- obtaining second data (D2) indicative of a deviation (dSoH) of a state of health per battery cell (16) of the subset (18) of battery cells from a second statistical parameter, the second statistical parameter descriptive of a collective state of health for the subset (18) of battery cells,
- obtaining third data (D3) indicative of a statistical distance measure per battery cell (16) of the subset (18) of battery cells, based on the first data (D1) and based on the second data (D2), and
- comparing the third data (D3) to a predefined distance threshold (DT) and, based on the comparing, providing fourth data (D4) indicative of an anomaly for the one or more battery cells (16) associated with a statistical distance measure exceeding the predefined distance threshold (DT) or being smaller than the predefined distance threshold.

2.   The method of claim 1, wherein the statistical distance measure is configured to account for statistical covariance between the first data (D1) and the second data (D2).

3.   The method of claim 1 or 2, wherein the statistical distance measure is a Mahalanobis-type distance ($d_M$).

4.   The method of any one of the preceding claims, wherein the first statistical parameter is a measure of central tendency and/or wherein the second statistical parameter is a measure of central tendency.

5.   The method of any one of the preceding claims, wherein the state of charge is relatable to a ratio between an amount of electrical energy currently stored in a battery cell (16) and a maximum amount of electrical energy storable in the battery cell (16).

6.   The method of any one of the preceding claims, wherein the state of health is described by one or more of

- a capacitance of the associated battery cell (16),
- an internal electrical resistance of the associated battery cell (16),
- a voltage providable by the associated battery cell (16),
- a self-discharge indicator of the associated battery cell (16),
- an indicator of an ability of the associated battery cell (16) to accept a charge,
- a number of charging cycles of the associated battery cell (16),
- a number of discharging cycles of the associated battery cell (16),
- an age of the associated battery cell (16),
- a temperature of the associated battery cell (16),
- a total energy with which the associated battery cell (16) is chargeable, and
- a total energy dischargeable from the associated battery cell (16).

7.   The method of any one of the preceding claims, wherein the subset (18) of battery cells forms part of the same module (14) of the battery assembly (12).

8.   A method for controlling a battery assembly (12) for a vehicle (10), the method comprising:

- detecting an anomaly in one or more battery cells (16) of the battery assembly (12) using the method of any one of the preceding claims, and
- causing an anomaly mitigation measure in respect of the one or more battery cells (16).

**9.** A data processing apparatus (24) comprising means for carrying out the method of any one of claims 1 to 7 or the method of claim 8.

**10.** A computer program (32) comprising instructions which, when the computer program (32) is executed by a computer, cause the computer to carry out the method of any one of claims 1 to 7 or the method of claim 8.

**11.** A computer-readable storage medium (30) comprising instructions which, when executed by a computer, cause the computer to carry out the method of any one of claims 1 to 7 or the method of claim 8.

**12.** A vehicle (10) comprising a data processing apparatus (24) of claim 9.

**13.** A use of a statistical distance measure for detecting an anomaly in one or more battery cells (16) of a battery assembly (12) for a vehicle (10).

**14.** The use of claim 13, wherein the statistical distance measure is a Mahalanobis distance $d_M$.

**15.** The use of claim 13 or 14, wherein the statistical distance measure is obtained based on first data (D1) indicative of a deviation (dSoH) of a state of charge per battery cell (16) of at least a subset (18) of the battery cells from a first statistical parameter, the first statistical parameter descriptive of a collective state of charge for the subset (18) of battery cells, and/or
second data (D2) indicative of a deviation (dSoH) of a state of health per battery cell (16) of the subset (18) of battery cells from a second statistical parameter, the second statistical parameter descriptive of a collective state of health for the subset (18) of battery cells.

Fig. 1

Fig. 2

Fig. 3

EP 4 733 789 A1

Fig. 4

Fig. 5

Fig. 6

**EUROPEAN SEARCH REPORT**

Application Number

EP 24 20 9026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/347785 A1 (NIU SHANGBING [CN] ET AL) 2 November 2023 (2023-11-02) | 13-15 | INV.<br>G01R31/396 |
| A | * the whole document * | 1-12 | |
| A | KR 2015 0037406 A (LG CHEMICAL CO., LTD.) 8 April 2015 (2015-04-08)<br>* paragraph [0029] - paragraph [0066] * | 1-15 | |
| A | US 2024/044992 A1 (DERNOTTE JEREMIE [US] ET AL) 8 February 2024 (2024-02-08)<br>* claim 4 * | 4 | |

TECHNICAL FIELDS
SEARCHED    (IPC)

G01R

The present search report has been drawn up for all claims

| Place of search | Date of completion of the search | Examiner |
|---|---|---|
| Munich | 5 May 2025 | Mazagão Guerreiro, R |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 20 9026

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2025

| Patent document cited in search report | Publication date | Patent family member(s) | Publication date |
|---|---|---|---|
| US 2023347785 A1 | 02-11-2023 | CN 115257457 A<br>EP 4312299 A2<br>JP 7634611 B2<br>JP 2023156356 A<br>KR 20230129953 A<br>US 2023347785 A1 | 01-11-2022<br>31-01-2024<br>21-02-2025<br>24-10-2023<br>11-09-2023<br>02-11-2023 |
| KR 20150037406 A | 08-04-2015 | NONE | |
| US 2024044992 A1 | 08-02-2024 | CN 117525639 A<br>DE 102023101070 A1<br>US 2024044992 A1 | 06-02-2024<br>08-02-2024<br>08-02-2024 |

EPO FORM P0459

For more details about this annex : see Official Journal of the European Patent Office, No. 12/82